# EUROPEAN PATENT APPLICATION

(11) **EP 4 503 137 A1**
(43) Date of publication of application: **05.02.2025**
(21) Application number: 24191703.8
(22) Date of filing: 30.07.2024
(51) Int. Cl.: H01L 29/08, H01L 21/04, H01L 29/10, H01L 29/78, H01L 21/336

(54) **MANUFACTURING PROCESS FOR SILICON CARBIDE POWER DEVICES WITH VARIABLE DOPANT CONCENTRATION**

(30) Priority: 04.08.2023 IT 202300016734
(71) Applicant: STMicroelectronics International N.V., 1228 Plan-les-Ouates, Geneva (CH)
(72) Inventor: CAMALLERI, Cateno Marco, 95125 CATANIA (IT); SAGGIO, Mario Giuseppe, 95020 ACI BONACCORSI (CT) (IT); GUARNERA, Alfio, 95039 TRECASTAGNI (CT) (IT); FRAZZETTO, Alessia Maria, 95030 SANT'AGATA LI BATTIATI (CT) (IT)
(74) Representative: Studio Torta S.p.A.

(57) **Abstract**

A manufacturing process for a vertical-conduction power device (1) includes: from a layer (10) containing semiconductor material with a lattice structure having spatial symmetry, growing an epitaxial layer (12), having the lattice structure with spatial symmetry and a first electrical conductivity; forming body regions (15) having a second electrical conductivity, opposite to the first electrical conductivity, in the epitaxial layer (12); and forming a current-spreading layer (30) in the epitaxial layer (12) between the body regions (15). Forming the body regions (15) includes carrying out a body channelling ion implantation, using a body mask (105). Forming the current-spreading layer (30) includes: forming shallow damaged regions (50) in the body regions (15) through the body mask (105) so that the lattice structure is altered in the shallow damaged regions (50); and carrying out a current-spreading channelling ion implantation, using the shallow damaged regions (50) as implantation mask.

## Description

### Technical field

The present invention relates to a manufacturing process for silicon carbide power devices with variable dopant concentration.

### Context

As is known, semiconductor materials having a wide bandgap, for example, greater than 1.1 eV, low ON-state resistance, high thermal conductivity, high operating frequency, and high charge-carrier saturation velocity make it possible to obtain electronic devices, such as diodes and transistors, having a higher performance than electronic devices of silicon, in particular for power applications (i.e., for operating voltages, for example, comprised between 600 V and 1300 V, or in specific operating conditions, such as high temperature).

In detail, it is known to obtain such electronic devices starting from a wafer of silicon carbide (SiC) in one of its polytypes, for example, 3C-SiC, 4H-SiC and 6H-SiC, which are distinguished by the characteristics listed above. Electronic power devices that may be obtained using semiconductors of the SiC type may, for example, be vertical-conduction MOSFETs or JFETs.

Ion implantation is today a consolidated technique for introduction of dopants into the silicon carbide. On account, in fact, of the low diffusiveness of SiC as compared to other semiconductor materials (such as silicon), diffusion of dopants may not be a convenient technique to use. Epitaxial growth might further not be an effective alternative, in particular for locally confined dopings.

As is known, in addition to the energy and the type of ions used, the crystalline structure of SiC has an effect, during implantation, on the depth distribution obtained. In fact, the so-called channelling may considerably increase the depth of penetration of the dopant ions in the crystalline material as compared to an amorphous target. This phenomenon may occur if the direction of the incident ion beam is substantially parallel to the main crystallographic axes or planes, within ranges that are well defined and contained (i.e., within the so-called "critical channelling angle"). In these directions, the reduction of the loss of energy per length of path of the ions is smaller, with the benefit that the ions may move in greater depth in the target. In fact, when the implantation is carried out along a crystallographic axis using SiC technology, the deepest channelling ions may penetrate for a distance that is many times greater than the range expected for the corresponding random implantation, given the same implantation energy used.

In order to form implanted regions that are locally confined, both in terms of shape and in terms of doping profiles, it is known to use hard implantation masks, for example, of silicon oxide (SiO₂), configured to locally shield a SiC die or chip during implantation. However, the present applicant has found that the use of hard masks may cause problems of planarity of the layer to which the mask is applied, after removal of the mask itself. The hard masks may, in fact, cause lattice stress on the SiC substrates.

Furthermore, the use of hard masks may not be compatible, i.e., may be difficult to scale, with progressive increase in the density of elementary cells that may be obtained in a same die, consequent to a decrease in the dimensions thereof (in technical jargon, "shrinkage"), i.e., consequent to a reduction of the "pitch" of the device, with the aim of increasing the current that may be extracted, in use, from the power device. In fact, in view of shrinkage of the elementary cells and of their consequent mutual approach, the processes based upon use of masks may present problems of alignment between regions belonging to layers arranged on top of one another of the die, with the possible onset of undesired electrical phenomena on account of layouts that do not correspond to the design specifications. Not least, the definition of regions of the SiC die with variable doping profiles, for the purposes of a parameterization of the electrical characteristics of the device (such as ON-state resistance, shielding from high electrical fields of the gate areas, etc.), may prove complex using implantation masks.

### Summary

Consequently, the aim of the present invention is to overcome or at least mitigate the disadvantages and limitations of the prior art.

According to the present invention, a manufacturing process for silicon carbide power devices with variable dopant concentration is provided, as defined in the annexed claims.

### Brief description of the drawings

For a better understanding of the present invention preferred embodiments thereof are provided, by way of nonlimiting example, with reference to the attached drawings, wherein:
- Figure 1 is a cross-sectional view through a power device according to one embodiment of the present invention;
- Figures 2A-2I are cross-sectional views through a semiconductor wafer in successive machining steps of a manufacturing process according to one embodiment of the present invention;

- Figure 3 is a simplified block diagram regarding the process of Figures 2A-2I;
- Figure 4 is a cross-sectional view through a power device according to a different embodiment of the present invention;
- Figure 5 shows an enlarged detail of Figure 4; and
- Figure 6 is a simplified block diagram regarding a manufacturing process according to a different embodiment of the present invention.

### Description of embodiments

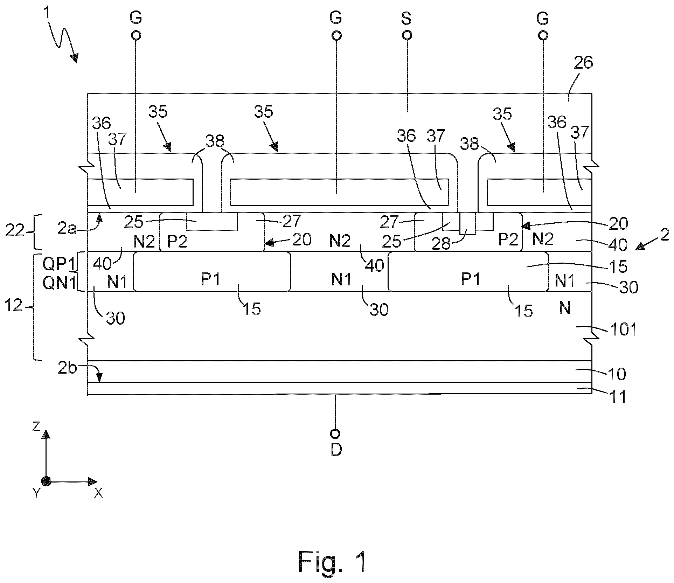

A power device manufactured according to one embodiment of the present invention is illustrated in a part thereof in Figure 1 and is designated by the number 1. The power device 1 is, for example, a MOSFET - in particular a power MOSFET, even more in particular a vertical-conduction MOSFET obtained using silicon carbide (SiC) technology - and is housed in a die or chip not illustrated in the attached figures. Hereinafter, the power device 1 will consequently also be referred as "MOSFET" in an interchangeable way and without this implying any loss of generality.

Figure 1 shows, in a cross-sectional view thereof, the MOSFET 1 in a reference system of mutually orthogonal axes X, Y, Z.

The MOSFET 1 comprises a plurality of elementary cells - just one of which is illustrated in the attached figures - that are the same as one another and arranged in a same die so as to share a drain terminal D, a gate terminal G, and a source terminal S; i.e., the elementary cells are electrically connected in parallel to one another.

The MOSFET 1 is formed in a body 2 of semiconductor material. The body 2 is delimited at the top by a front side 2a and at the bottom by a back side 2b, opposite to one another in the direction of the axis Z. The body 2 may comprise a substrate or else a substrate on which one or more epitaxial layers are grown and is made of silicon carbide, in one of its polytypes, here the 4H-SiC polytype.

In one embodiment, in particular, the body 2 comprises a substrate 10, which is delimited at the bottom by the back side 2b, a first epitaxial layer 12 on the substrate 10 and a second epitaxial layer 22, which extends over the first epitaxial layer 12 and is delimited at the top by the front side 2a.

The substrate 10 is made of monocrystalline semiconductor material, for example, silicon carbide in one of its polytypes, here the polytype 4H-SiC, and has a lattice structure with spatial symmetry; the first and second epitaxial layers 12, 22 are made of the same material and preserve the same crystalline structure.

A drift region 101, a first current-spreading layer (hereafter, simply "first CSL") 30 and a plurality of deep body regions 15 (two of which are illustrated in Figure 1) are formed in the first epitaxial layer 12. A second current-spreading layer (hereafter, simply "second CSL") 40, a plurality of shallow body regions 20 (two of which are illustrated in Figure 1) and a plurality of source regions 25 (two of which are illustrated in Figure 1) are formed in the second epitaxial layer 22.

The body 2 of semiconductor material of Figure 1, i.e., the substrate 10 and the drift region 101, have a first electrical conductivity, for example, of an N type. The deep body regions 15 have a second electrical conductivity, of a P type, opposite to the first electrical conductivity, and have a first doping level (or dopant concentration) P1. The first CSL 30 is of an N type and has a second doping level N1. The shallow body regions 20 are of a P type and have a third doping level P2. The second CSL 40 is of an N type and has a fourth doping level N2. The first and third doping levels P1, P2 may be different from one another, and likewise the second and fourth doping levels N1, N2 may be different from one another. In any case, the first doping level P1 and the second doping level N1 are selected so that, when the overall volume of the deep body regions 15 and of the first CSL 30 is considered, a first overall charge QP1 in the deep body regions 15 is significantly greater than a second overall charge QN1 in the first CSL 30. Typically, the first overall charge QP1 in the deep body regions 15 is at least five times greater than the second overall charge QN1 in the first CSL 30. Finally, the plurality of source regions 25 has the first electrical conductivity.

In the first epitaxial layer 12, adjacent deep body regions 15 are separated, along the axis X, by portions of the first CSL 30 and, in the second epitaxial layer 22, adjacent shallow body regions 20 are separated, along the axis X, by portions of the second CSL 40. Further, each shallow body region 20 at least partially overlies respective deep body regions 15, being in contact therewith, and the second CSL 40 at least partially overlies the first CSL 30, being in contact therewith.

Each source region 25 extends from the front side 2a and is at least partially contained in respective shallow body regions 20. At least one of the source regions 25 of each elementary cell comprises a body-contact region 28, which extends from the front side 2a as far as the respective shallow body region 20. Further, each source region 25 and the second CSL 40 laterally delimit a channel region 27 in a respective shallow body region 20.

The deep body regions 15, the shallow body regions 20, the source regions 25, and the body-contact regions 28 extend in a direction parallel to the axis Y in the form of strips.

The superposition of the first and second epitaxial layers 12, 22 is such that, in use, i.e., when the voltage between the gate terminal G and the source terminal S (V_{GS}) is greater than a conduction threshold voltage (V_{TH}) of the elementary cell, a current may flow between the source terminal S and the drain terminal D, through each channel region 27, the second CSL 40 and the first CSL 30 and the drift region 101. The first and second CSLs 30, 40 form in fact enrichment layers having the function of modulating locally the resistance encountered by the charge carriers (and, more in general, of improving the value of ON-state resistance of the MOSFET 1), and the drift region 101 forms, in use, the drift layer of the charge carriers.

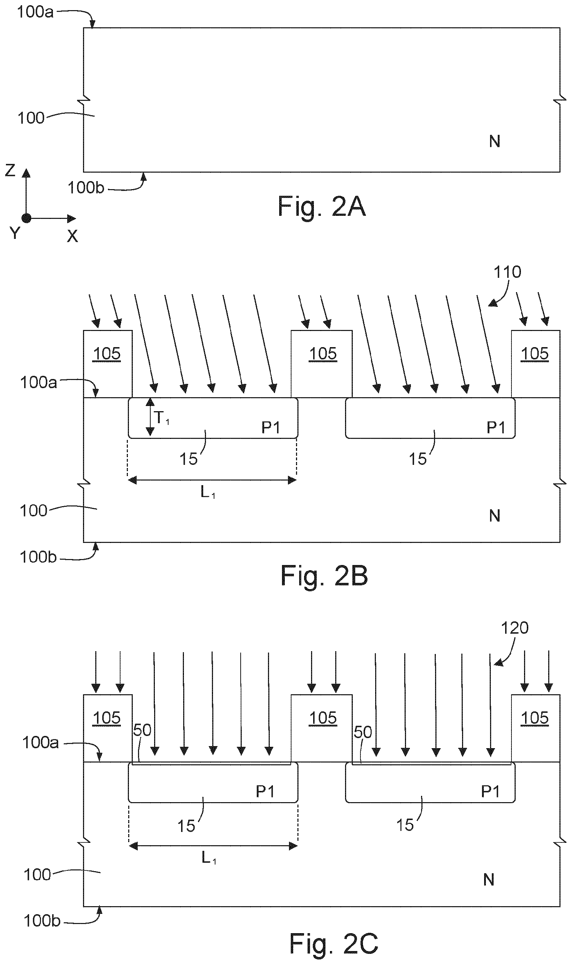

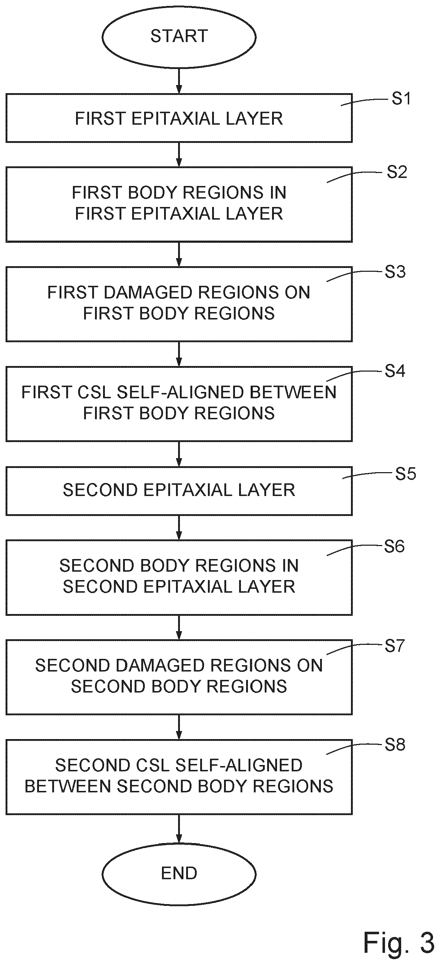

The body 2, and more in general the MOSFET 1 of Figure 1, is obtained by the manufacturing process forming the subject of the present invention, the successive steps of which are illustrated in Figures 2A-2I and schematically in the flowchart of Figure 3.

Figure 2A shows a cross-sectional view of a wafer 100 of silicon carbide (4H-SiC polytype), here having the first electrical conductivity (of an N type) and a first surface 100a and a second surface 100b opposite to one another in the direction of the axis Z. The wafer 100 initially comprises the substrate 10, on which the first epitaxial layer 12 is formed by a first epitaxial growth (first step S1), for example, with a thickness along the axis Z comprised between 1 µm and 60 µm. The crystalline, or lattice, structure of the first epitaxial layer 12 enables ion implantation by exploiting the channelling phenomenon.

The deep body regions 15 and, subsequently, the first CSL 30 are formed by channelling ion implantation. Channelling implantation is obtained when the ion beam during implantation is aligned with the channelling directions: for example, in SiC, the 000-1 direction or the 11-23 direction. Typically, the substrates are cut from ingots grown in the 000-1 direction, with a surface inclined (due to cutting of the wafers) by 4° for substrates of 150 mm or 200 mm in diameter. To make channelling implantations on a 000-1 wafer the ion beam during implantation is oriented with a tilt of 4°, and for a wafer grown in the 11-23 direction with a tilt of 13° or 21°.

With reference to Figure 2B, which identifies a second step S2 of the manufacturing process, a deep-body mask 105 is applied on the first surface 100a of the wafer 100. The deep-body mask 105 exposes portions of the wafer 100 where the deep body regions 15 are to be formed. Using the deep-body mask 105, a first channelling ion implantation of dopant ions is carried out (here indicated by arrows 110, inclined with respect to the axis Z to indicate a channelling implantation), of a P type, i.e., corresponding to the second electrical conductivity opposite to the first electrical conductivity of the wafer 100. The first channelling ion implantation is carried out using, for example, ions of aluminium (Al) or boron (B) and an implantation energy comprised between 20 keV and 2000 keV. The deep body regions 15 are thus defined, with a first thickness T₁ along the axis Z, starting from the first surface 100a, comprised between 0.5 and 5 pm, with a first dimension L₁ along the axis X comprised between 1 and 10 pm, and with the first doping level P1 of the order of 1×10¹⁷ to 1×10¹⁹ atoms/cm³.

According to one embodiment, the wafer 100 subsequently undergoes a step of annealing for activation of the dopant ions and for reduction of defects in the crystal lattice that may be caused by implantation.

During a third step S3 (Figure 2C), the deep-body mask 105 is used for creating a plurality of first intentionally damaged regions (also referred to simply as "IDRs") 50 for the purposes of self-aligned formation of the first CSL 30, as described hereinafter. The first damaged regions 50 are surface regions of the wafer 100 and, given that the deep-body mask 105 is again used, the first damaged regions 50 are obtained in regions corresponding to respective deep body regions 15.

The present applicant has in fact found that the effect of channelling is altered by intentional damage of a surface region of the wafer 100. Said damage may be obtained, for example, by a first random ion implantation (i.e., a non-channelled one) of non-reactive or non-dopant species (indicated by arrows 120 in Figure 2C), which cause damage to the crystal lattice of the wafer 100, without locally altering the conductive characteristics thereof. Chemical species suited for this purpose include, for example, ions of silicon (Si), argon (Ar), germanium (Ge), helium (He).

Thus, according to an aspect of the present invention, the first damaged regions 50 are formed at the first surface 100a and are aligned with (along the axes X and Y) and defined in the respective deep body regions 15, so as to alter or inhibit locally channelling in the subsequent implantation step to form the first CSL 30. Each first damaged region 50 extends to a maximum depth, in the wafer 100 starting from the first surface 100a, comprised, for example, between 0.05 and 0.2 µm (extremes included). The thickness (depth along the axis Z) of each first damaged region 50 may be uniform or else may vary between a minimum value of 0.05 µm and a maximum value of 0.2 µm. As illustrated in Figure 2C, thanks to the use of the deep-body mask 105 also in the third step S3, each first damaged region 50 has an extension along the axis X practically equal to the first dimension L₁ of the respective deep body regions 15.

To form the first damaged regions 50 there may be used implantation doses higher than 10¹³ atoms/cm² and energies sufficient to cause a displacement of the atoms from the crystalline edifice for the desired depth (for example, energy in the 30 - 300 keV range). The implantation that causes damage is carried out in the absence of channeling conditions, and annealing of the wafer 100 during the process is avoided so as not to remove the damage produced.

According to a further embodiment, the first damaged regions 50 are obtained by one or more steps of localized etching of the first surface 100a through the deep-body mask 105, at the deep body regions 15. For instance, a RIE (Reactive Ion Etching) process may be used with characteristics of physical etching, i.e., a plasma ion bombardment, with Ar ions. The depths that may be obtained are, for example, equal to 0.1 µm.

The lattice structure of the wafer 100 in the first damaged regions 50 is different from the lattice structure of the undamaged regions of the wafer 100. In particular, the wafer 100, in the case where it is damaged, has an amorphous structure or a disorderly crystalline structure or a lattice structure without the spatial symmetry of the portions of the wafer 100 in which the intentional damage is absent.

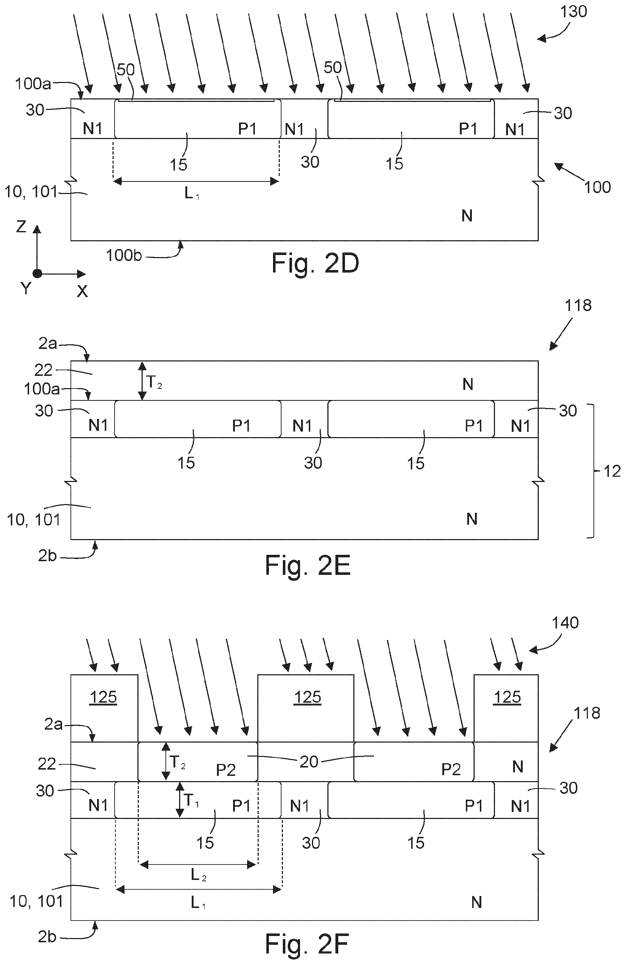

Once the deep-body mask 105 has been removed, the first damaged regions 50 extend over portions of the first epitaxial layer 12, where the first CSL 30 of the MOSFET 1 of Figure 1 is absent. In other words, the first damaged regions 50 are formed (third step S3) in portions complementary with respect to the portions of the wafer 100 in which the first CSL 30 is to be implanted. Figure 2D refers to a fourth step S4 of the manufacturing process and shows, in fact, how the first damaged regions 50 act as implantation mask in regard to a second channelling ion implantation of dopant ions (here indicated by arrows 130, inclined with respect to the axis Z to indicate a channelling implantation) of an N type, i.e., corresponding to the first electrical conductivity.

In detail, the entire wafer 100 is exposed to the second channelling ion implantation, but the first CSL 30 is obtained practically exclusively in the portions of the wafer 100 without surface damage, i.e., outside the deep body regions 15. In this way, the deep body regions 15 are shielded from the second channelling ion implantation, and, simultaneously, the first CSL 30 is defined in a self-aligned way with respect to the deep body regions 15 within the first epitaxial layer 12, as far as a desired depth determined by the implantation conditions.

The second channelling ion implantation (arrows 130) is carried out using, for example, ions of phosphorus (P) or nitrogen (N) and an implantation energy comprised between 20 keV and 2000 keV. These parameters define: the second doping level N1 between the plurality of deep body regions 15, for example, of the order of 10¹⁷ atoms/cm³ or else between 2 and 20 times the doping level of the portion of the semiconductor wafer that houses it; and a depth along the axis Z, starting from the first surface 100a, which in the MOSFET 1 is, for example, equal to the first thickness T₁ of the deep body regions 15. In particular, the first doping level P1 of the deep body regions 15 and the second doping level N1 of the first CSL 30 are selected, in relation also to the total volume of the deep body regions 15 and of the first CSL 30, so that the first overall charge QP1 in the deep body regions 15 is at least five times greater than the second overall charge QN1 in the first CSL 30.

In this step, thin implanted layers with a maximum thickness of 0.3 µm may be formed in the first damaged regions 50. In other words, CSLs may be confined superficially in the damaged regions. The present applicant has found that the presence of such thin CSLs, in relation to the overlying layers formed in subsequent steps, does not affect operation of the MOSFET 1. However, as described also hereinafter, and as applied in the manufacturing process forming the subject of the present invention, to prevent possible crystallographic defects in the layers overlying the damaged regions, the first damaged regions 50 are selectively removed before the subsequent machining steps, for example, by etching of the wafer 100 in a hydrogen (H₂) environment.

Processing of the first epitaxial layer 12 of the MOSFET 1 of Figure 1 is thus completed. In particular, the drift region 101 is also itself in this way defined in a portion of the first epitaxial layer 12 not occupied by the first CSL 30 and by the deep body regions 15.

Next (Figure 2E, step S5), the second epitaxial layer 22 is formed on the wafer 100 by a second epitaxial growth. In detail, the second epitaxial layer 22 is, like the wafer 100, made of silicon carbide (4H-SiC polytype), i.e., of a material that enables ion implantation by exploiting the channelling phenomenon, and has a doping, for example, of the order of 1×10¹⁵ to 1×10¹⁷ atoms/cm³. The second epitaxial layer 22 is grown for a second thickness T₂ comprised between 0.1 and 3 µm and, for example, equal to 1.5 µm (measured starting from the first surface 100a).

The wafer 100 and the second epitaxial layer 22 form a work wafer 118, which basically corresponds to the body 2 and extends between the front side 2a and the back side 2b of the body 2. The work wafer 118 is processed, as described for the steps subsequent to the fifth step S5, so as to define the structures of the MOSFET 1 present in the second epitaxial layer 22.

With reference to Figure 2F (sixth step S6), applied on the second epitaxial layer 22 is a shallow-body mask 125, which exposes portions of the second epitaxial layer 22 where the shallow body regions 20 are to be formed. In particular, the shallow-body mask 125 has openings in positions corresponding, in the direction of the axis Z, to respective deep body regions 15, not necessarily of the same dimensions. Using the shallow-body mask 125, a third channelling ion implantation of dopant ions is carried out (here indicated by arrows 140, inclined with respect to the axis Z to indicate a channelled implantation), of a P type, i.e., corresponding to the second electrical conductivity opposite to the first electrical conductivity of the second epitaxial layer 22. The third channelling ion implantation is carried out using, for example, ions of aluminium (Al) or boron (B) and an implantation energy comprised between 20 keV and 2000 keV. The shallow body regions 20 thus defined have a depth equal to the second thickness T₂ of the second epitaxial layer 22, a second dimension L₂ along the axis X comprised between 1 and 10 µm, and the third doping level P2 of the order of 1×10¹⁷ to 1×10¹⁹ atoms/cm³.

In the work wafer 118 of Figure 2F, and thus in the MOSFET 1 of Figure 1, the depth of the shallow body regions 20 starting from the front side 2a corresponds to the thickness of the second epitaxial layer 22. Further, the shallow-body mask 125 is such that the shallow body regions 20 of the MOSFET 1 are aligned, in a direction parallel to the axis Z, to the deep body regions 15. This having been said, each shallow body region 20 overlies a respective deep body region 15, in contact therewith. The first and second dimensions L₁, L₂ are different from one another, and, in particular, each shallow body region 20 has a dimension along the axis X smaller than the corresponding dimension of the respective deep body region 15.

The first and second dimensions L₁, L₂ are design parameters of the MOSFET 1 corresponding to the electrical performance of the latter, as described in greater detail hereinafter. The first and second dimensions L₁, L₂ may thus be selected, adjusting the respective deep-body masks 105 and shallow-body masks 125, so that each deep body region 15 will alternatively have a dimension along the axis X greater than (Figure 1), smaller than, or the same as the extension of respective shallow body regions 20 (for L₁ > L₂, L₁ < L₂ or L₁ = L₂, respectively) according to the desired performance.

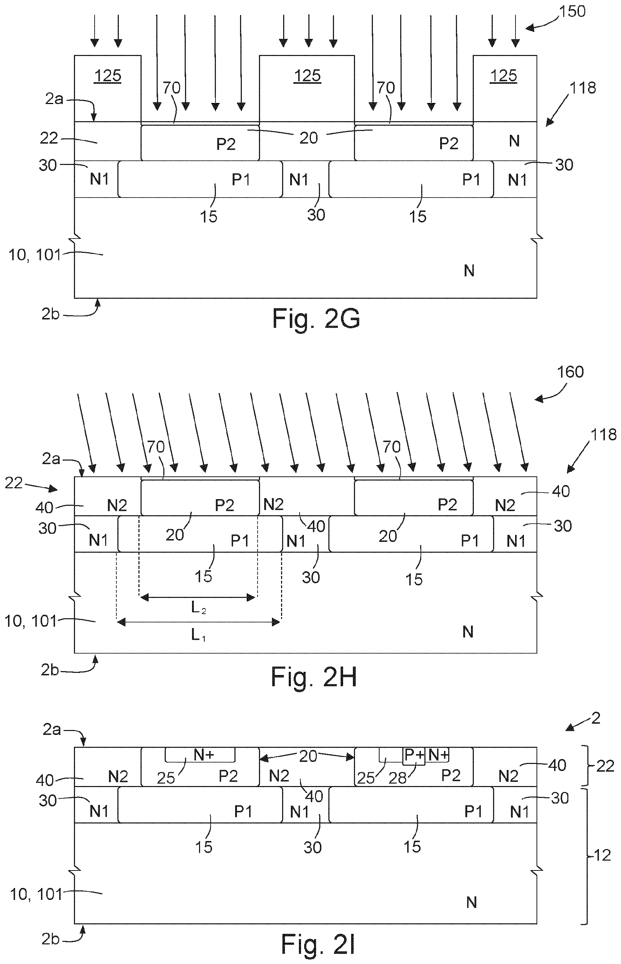

During a seventh step S7 (Figure 2G), the shallow-body mask 125 is used for creating a plurality of second regions 70 intentionally damaged for the purposes of a self-aligned formation of the second CSL 40. The second damaged regions 70 are surface regions of the second epitaxial layer 22, aligned with (along the axes X and Y) and defined in the respective shallow body regions 20 in order to alter or inhibit channelling locally.

The above damage may be obtained, for example, by a second random (i.e., non-channelled) ion implantation of non-reactive or non-dopant species (in Figure 2G indicated by arrows 150), i.e., such as to cause damage to the crystal lattice of the second epitaxial layer 22, without locally altering the conductive characteristics thereof. Chemical species designed for this purpose include, for example, ions of silicon (Si), argon (Ar), germanium (Ge), helium (He).

To form the second damaged regions 70 there may be used implantation doses higher than 10¹³ atoms/cm² and energies sufficient to cause a displacement of the atoms from the crystalline edifice for the desired depth (for example, energy in the 30 - 300 keV range). Each second damaged region 70 extends to a maximum depth, in the second epitaxial layer 22 starting from the front side 2a, comprised, for example, between 0.05 and 0.2 µm (extremes included).

Once the shallow-body mask 125 has been removed, the damaged regions 70 extend over portions of the second epitaxial layer 22 where the second CSL 40 of the MOSFET 1 of Figure 1 is absent. In other words, the second damaged regions 70 are formed (seventh step S7) in portions complementary to the portions of the second epitaxial layer 22 in which the second CSL 40 is to be implanted. Figure 2H regards an eighth step S8 of the manufacturing process and shows, in fact, how the second damaged regions 70 act as implantation mask in regard to a fourth channelling ion implantation of dopant ions (here indicated by arrows 160, inclined with respect to the axis Z to indicate a channelled implantation) of an N type, i.e., corresponding to the first electrical conductivity.

In detail, the entire second epitaxial layer 22 is exposed to the fourth channelling ion implantation, but formation of the second CSL 40 by channeling is obtained practically exclusively in the portions of the epitaxial layer 22 without surface damage, i.e., outside the shallow body regions 20. In this way, the shallow body regions 20 are shielded from the fourth channelling ion implantation, and, simultaneously, the second CSL 40 is defined in a self-aligned way within the second epitaxial layer 22 and with respect to the plurality of shallow body regions 20.

The fourth channelling ion implantation (arrows 160) is carried out using, for example, nitrogen or phosphorus ions and an implantation energy comprised between 20 keV and 2000 keV. Said parameters define: the fourth doping level N2 between the plurality of shallow body regions 20, for example, of the order of 10¹⁷ atoms/cm³ or else comprised between 2 and 20 times the doping level of the portion of the semiconductor layer that houses it; and a depth along the axis Z, starting from the front side 2a, that in the MOSFET 1 is, for example, equal to the second thickness T₂ of the shallow body regions 20.

At the end of the fourth channelling ion implantation, the second CSL 40 of the MOSFET 1 overlies, in contact, the first CSL 30 and at least partially overlies, in contact, the deep body regions 15.

The second damaged regions 70 are then selectively removed, for example, by etching in a hydrogen environment (H₂) of the work wafer 118.

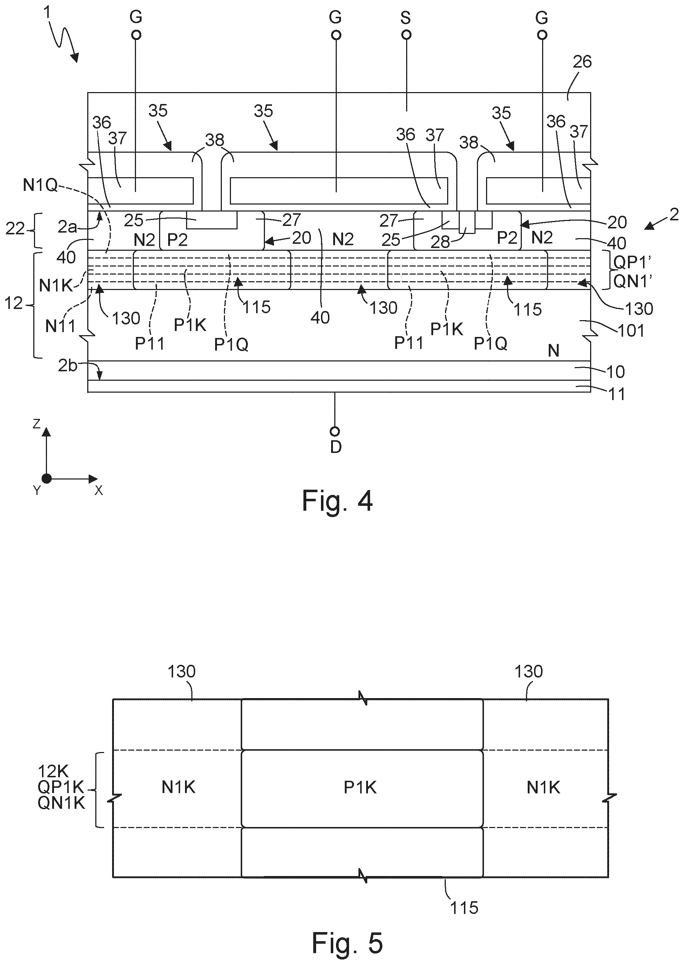

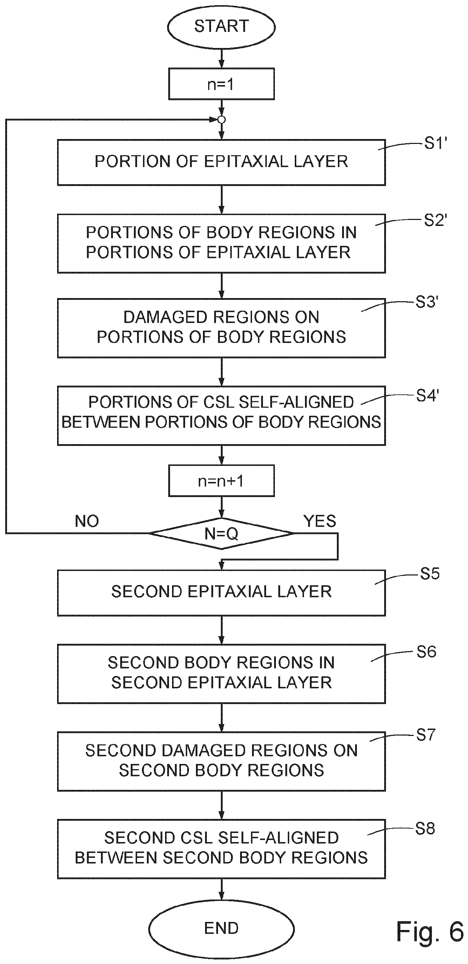

In one embodiment, illustrated in Figure 4 and in the enlarged detail of Figure 5, the deep body regions and the first CSL, here designated by 115 and 130, respectively, may be obtained by repeating, for a programmed number Q of iterations, steps S1'-S4' similar to the steps S1-S4 already described. In practice, at each iteration: a portion of the first epitaxial layer 12 is grown (S1', Figure 6); a channelling ion implantation of dopant ions is carried out using the deep-body mask 105 (S2', Figure 6), thus obtaining portions of deep body regions 115 with respective concentrations P11, ..., P1K, ..., P1Q; intentionally damaged regions (not illustrated) are formed on the surface of respective portions of deep body regions 115 (S3', Figure 6), by one or more localized etching steps through the deep-body mask 105; and portions of the first CSL 130 with respective concentrations N11, ..., N1K, ..., N1Q, are formed by channelling ion implantation, using the damaged regions as implantation mask (S4', Figure 6). The concentrations P11, ..., P1K, ..., P1Q and N11, ..., N1K, ..., N1Q of the dopant species may be selected according to the design preferences, in any case so that a first overall charge QP1' in the deep body regions 115 is significantly greater, typically at least five times greater, than a second overall charge QN1' in the first CSL 130 (added in Figure 4). Furthermore, the concentrations P1K, ..., P1Q and N11, ..., N1K, ..., N1Q of the dopant species may be selected so that in each K-th portion (Figure 5) of epitaxial layer a first overall layer charge QP1K in the portions of deep body regions 115 is significantly greater, typically at least five times greater, than a second overall layer charge QN1K in the portion of the first CSL 130.

The process then proceeds with the steps S5-S8 already described.

The elementary cells of the MOSFET 1 are formed following upon the eighth step S8 of the process of manufacture of the body 2. In detail, with reference to Figure 2I, where just one elementary cell is illustrated, the source regions 25 (having the first electrical conductivity) and the body-contact regions 28 (having the second electrical conductivity) are defined, where present, by formation techniques known in the sector, such as implantation, diffusion, etc.

Each source region 25 and each body-contact region 28 extend, starting from the front side 2a of the epitaxial layer 22, in respective shallow body regions 20 and for respective depths of, for example, 0.2 µm and 2 µm. The source regions 25 have a doping level, denoted by N+, typically greater than the N doping level of the drift region 101 and of the order of 1×10¹⁸ to 1×10²⁰ atoms/cm³, each with an extension along the axis X, for example, of 2 µm. The body-contact regions 28 have a doping, denoted by P+, of the order of 1×10¹⁸ to 1×10²⁰ atoms/cm³.

The second layer 22 of the MOSFET 1 of Figure 1 is thus complete, and in practice also the entire body 2.

Next, a plurality of gate regions 35 are formed on the front side 2a of the body 2 by steps of deposition and lithographic definition, using techniques typical of the sector. The gate regions 35 are each formed by: a gate insulating layer 36 (for example, a silicon oxide), in contact with the front side 2a of the body 2; a gate conductive layer 37 (for example, a polysilicon layer), directly overlying the gate insulating layer 36; and a passivation layer 38, which coats the gate conductive layer 37 and, together with the gate insulating layer 36, seals the gate conductive layer 37. In detail, the gate insulating layer 36 of each gate region 35 extends over a respective portion of the second CSL 40, on two channel regions 27 adjacent to and delimiting said respective portion of the second CSL 40 and partially on two source regions 25 adjacent to the respective channel regions 27. The gate conductive layers 37 of the gate regions 35 are electrically connected in parallel, in a way here not illustrated, thus forming the gate terminal G of the MOSFET 1.

The MOSFET 1 further comprises a source-metallization region 26, for example, of metal material and/or metal silicide, which forms the source terminal S of the MOSFET 1 and extends over the front side 2a of the body 2, in direct electrical contact with the source regions 25 and the body-contact regions 28. The body-contact regions 28 are in fact used for biasing, at the electrical potential of the source terminal S, the shallow body regions 20 and thus the deep body regions 15.

Finally, the MOSFET 1 comprises a drain-metallization region 11, of conductive material, for example, a metal or a silicide, which extends over the back side 2b of the body 2 (in a direction opposite to the source-metallization region 26), in direct electrical contact with the substrate 10, and forms the drain terminal D of the MOSFET 1.

The MOSFET 1 manufactured according to the process of the present invention exhibits improved electrical performance. The use of contained implantation energies, possibly thanks to the channeling phenomenon, makes it possible to obtain a reduced lateral dispersion of dopant ions and thus a profile of concentration of the dopant ions in the body 2 that may be controlled and is in conformance with what is established in the design stage. Furthermore, given that the first and second layers 12, 22 are defined using contained implantation energies, it is possible to use thin masks, for which it is easier to obtain a greater lateral definition.

The technique of resorting to intentionally damaged regions (IDRs), carried out in random implantation conditions (i.e., in the absence of channelling) on already implanted regions (here, for example, obtained with channelled implantation), makes it possible to improve further the lateral definition, in particular because regions formed in steps subsequent to the damage may be self-aligned with respect to regions already present, which present, for example, different doping levels or opposite doping levels. By altering or inhibiting channelling locally by means of the damage it is possible, in fact, to select at will the extension of the regions to be formed in subsequent steps (by means of channelling) and protect the regions already present from the subsequent channelled implantations, preserving the desired doping level thereof. The superficially damaged regions act, in fact, as implantation masks in regard to subsequent channelled implantations.

In this way, it is possible to define precisely and with lower production costs (contained implantation energies, self-alignment) doping levels, within layers (here of silicon carbide) grown epitaxially, with profiles that may be variable along the dimension of the layer itself (here, for example, in planes XY) and in the direction of the superposition of the layers (here along the axis Z).

In the MOSFET 1, this leads to a greater flexibility in defining the junction between the body regions and the drain region and in controlling the concentration of the conductive channel, with an overall benefit in terms of scalability of the MOSFET 1 in the shrinkage direction, and thus in terms of increase of the number of elementary cells.

The first and second dimensions L₁, L₂, like the first and second thicknesses T₁, T₂ and the first and third doping levels P1, P2 are in fact design parameters of the MOSFET 1 corresponding to the electrical performance of the latter. In detail, the deep body regions 15 and the shallow body regions 20 form an overall body structure that has the function of shielding the layers overlying the body 2 - in particular, the gate insulating layers 36 - in regard to the intense electrical fields of the body 2. An improved shielding may consequently lead to reduced switching-on voltages of the power device.

The presence of the deep body regions 15 means that, when the MOSFET 1 is in an off state and the voltage between the source terminal S and the drain terminal D (V_{DS}) is high, for example, even higher than 400 V, the higher values of electrical field are obtained in depth in the body 2, at a distance from the front side 2a. This causes the electrical field to assume lower values in the shallower portions of the body 2 (here in the second CSL 40), in particular in the proximity of the gate insulating layers 36. Consequently, the MOSFET 1 exhibits reliable performance.

The first and second dimensions L₁, L₂ and, simultaneously, the first and second thicknesses T₁, T₂ and the first and third doping levels P1, P2 are selected so as to provide a shape to the body structure (in the MOSFET 1, for example, the shape of an upside-down T) and a doping profile that are functional to obtaining the desired electrical parameters (such as, precisely, shielding in regard to fields), also in relation to the dimensions of the individual elementary cell.

At the same time, also the first and second CSLs 30, 40 form a current-spreading structure, the dimensions of which (in relation to the shape and dimensions of the body structure) and the doping profile of which may be selected in a flexible way by means of the process according to the present invention. In particular, different dopant concentrations between the different CSLs enable effective modulation of the channel concentrations and thus of the electrical parameters of the device, further countering undesired phenomena, such as pinching, in use, of the body regions and uncontrolled variations of the ON-state resistance.

Finally, it is clear that modifications and variations may be made to what has been described and illustrated herein, without thereby departing from the scope of the present invention, as defined in the annexed claims.

For instance, the body structure may have shapes different from the one illustrated. The deep body regions may be less extensive (along the axis X) than the shallow body regions; in this case, the shallow body regions at least partially overlie the first CSL, in contact therewith. Alternatively, the deep body regions and the shallow body regions may have identical extension (along the axis X).

In a variant of the manufacturing process (not illustrated), the channelling ion implantations of the first and second CSLs 30, 40 are such as to define respective depths that are less or greater than the aforementioned first and second thicknesses T₁, T₂.

## Claims

1. A manufacturing process for a vertical-conduction power device (1) comprising:
- from a layer (10) containing semiconductor material with a lattice structure having spatial symmetry, growing a first epitaxial layer (12), having the lattice structure with spatial symmetry and a first electrical conductivity;
- forming first body regions (15; 115) having a second electrical conductivity, opposite to the first electrical conductivity, in the first epitaxial layer (12); and
- forming a first current-spreading layer (30; 130) having the first electrical conductivity in the first epitaxial layer (12) between the first body regions (15; 115) ;
wherein forming the first body regions (15; 115) comprises:
carrying out a first body channelling ion implantation, using a first body mask (105);
and wherein forming the first current-spreading layer (30; 130) comprises:
forming first shallow damaged regions (50) in the first body regions (15; 115) through the first body mask (105) so that the lattice structure is altered in the first shallow damaged regions (50); and
carrying out a first current-spreading channelling ion implantation, using the first shallow damaged regions (50) as implantation mask.

2. The manufacturing process according to claim 1, wherein forming the first shallow damaged regions (50) comprises carrying out one of the following:
a non-channelled random ion implantation of non-reactive or non-dopant ion species chosen in the group comprising ions of the following: silicon, argon, germanium, helium; and
a first chemical etch.

3. The manufacturing process according to claim 1 or claim 2, wherein a first doping level (P1) of the first body regions (15; 115) and a second doping level (N1) of the first current-spreading layer (30; 130) are selected so that a first overall charge (QP1; QP1') in the first body regions (15; 115) is at least five times greater than a second overall charge (QN1; QN1') in the first current-spreading layer (30; 130).

4. The manufacturing process according to any one of the preceding claims, comprising:
- from the first epitaxial layer (12), growing a second epitaxial layer (22), having the lattice structure with spatial symmetry and the first electrical conductivity;
- forming second body regions (20) having the second electrical conductivity, in the second epitaxial layer (22); and
- forming a second current-spreading layer (40) having the first electrical conductivity between the second body regions (20) of the second epitaxial layer (22);
wherein forming the second body regions (20) comprises:
carrying out a second body channelling ion implantation, using a second body mask (125);
and wherein forming the second current-spreading layer (40) comprises:
forming second shallow damaged regions (70) in the second body regions (20) through the second body mask (125) so that the lattice structure is altered in the second shallow damaged regions (70) of the second body regions (20); and
carrying out a second current-spreading channelling ion implantation, using the second shallow damaged regions (70) of the second body regions (20) as implantation mask.

5. The manufacturing process according to claim 4, wherein the second body mask (125) has openings in positions corresponding to respective first body regions (15; 115).

6. The manufacturing process according to claim 4 or claim 5, comprising removing the first shallow damaged regions (50) before growing the second epitaxial layer (22) .

7. The manufacturing process according to any one of claims 4 to 6, comprising removing the second shallow damaged regions (70).

8. The manufacturing process according to any one of claims 4 to 7, wherein the second body regions (20) extend in depth throughout the second epitaxial layer (22) as far as and in contact with respective first body regions (15; 115) .

9. The manufacturing process according to any one of claims 4 to 8, wherein the second current-spreading layer (40) extends in depth throughout the second epitaxial layer (22) as far as and in contact with the first epitaxial layer (12).

10. The manufacturing process according to claim 3 and any one of claims 4 to 9, wherein the first doping level (P1) of the first body regions (15; 115) is different from a third doping level (P2) of the second body regions (20), and/or the second doping level (N1) of the first current-spreading layer (30; 130) is different from a fourth doping level (N2) of the second current-spreading layer (40).

11. The manufacturing process according to any one of claims 4 to 10, wherein forming the second shallow damaged regions (70) comprises carrying out one of the following:
a second non-channelled random ion implantation of non-reactive or non-dopant ion species chosen in the group comprising ions of the following: silicon, argon, germanium, helium; and
a second chemical etch.

12. The manufacturing process according to any one of the preceding claims, comprising repeating iteratively:
- growing a portion of the first epitaxial layer (12), having the lattice structure with spatial symmetry and the first electrical conductivity;
- forming portions of the body regions (115) having the second electrical conductivity, in the last grown portion of the first epitaxial layer (12); and
- forming a portion of the first current-spreading layer (130) between the portions of the body regions (115) of the last grown portion of the first epitaxial layer (12) ;
wherein forming the portions of the body regions (115) of the last grown portion of the first epitaxial layer (12) comprises:
carrying out a respective body channelling ion implantation, using the first body mask (105);
and wherein forming the portion of the first current-spreading layer (130) comprises:
forming shallow damaged regions in the portions of the body regions (115) of the last grown portion of the first epitaxial layer (12) through the first body mask (105) so that the lattice structure is altered in the shallow damaged regions of the portions of the body regions (115) of the last grown portion of the first epitaxial layer (12); and
carrying out a respective current-spreading channelling ion implantation, using the shallow damaged regions of the portions of the body regions (115) of the last grown portion of the first epitaxial layer (12) as implantation mask.

13. A semiconductor wafer (100; 118) comprising:
- a substrate (10) containing semiconductor material with a lattice structure having spatial symmetry;
- an epitaxial layer (12; 22), arranged on the substrate (10) and having the lattice structure with spatial symmetry and a first electrical conductivity;
- body regions (15; 115; 20) having a second electrical conductivity, opposite to the first electrical conductivity, in the epitaxial layer (12; 22);
- shallow damaged regions (50; 70) in the body regions (15; 115; 20), wherein the lattice structure is altered in the shallow damaged regions (50; 70); and
- a current-spreading layer (30; 130; 40), having the first electrical conductivity, in the epitaxial layer (12; 22) between the body regions (15; 115; 20).

14. The semiconductor wafer (100) according to claim 13, wherein a first doping level (P1) of the body regions (15; 115) and a second doping level (N1) of the current-spreading layer (30; 130) are selected so that a first overall charge (QP1; QP1') in the body regions (15; 115) is at least five times greater than a second overall charge (QN1; QN1') in the current-spreading layer (30; 130).

15. A vertical-conduction power device (1) comprising:
- a substrate (10) containing semiconductor material with a lattice structure having spatial symmetry;
- an epitaxial layer (12), arranged on the substrate (10) and having the lattice structure with spatial symmetry and a first electrical conductivity;
- body regions (15; 115) having a second electrical conductivity, opposite to the first electrical conductivity, in the epitaxial layer (12);
- shallow damaged regions (50) in the body regions (15; 115), wherein the lattice structure is altered in the shallow damaged regions (50); and
- a current-spreading layer (30; 130), having the first electrical conductivity, in the epitaxial layer (12) between the body regions (15; 115).
